# EUROPÄISCHE PATENTSCHRIFT

(11) **EP 2 019 810 B1**
(45) Veröffentlichungstag und Bekanntmachung des Hinweises auf die Patenterteilung: **22.02.2012**
(21) Anmeldenummer: 07727177.3
(22) Anmeldetag: 21.03.2007
(51) Int. Cl.: B81B 7/00, H01L 23/057

(54) **CHIPGEHÄUSE MIT REDUZIERTER SCHWINGUNGSEINKOPPLUNG**
CHIP HOUSING WITH REDUCED COUPLING-IN OF VIBRATIONS
BOÎTIER DE PUCE À ACCOUPLEMENT D'OSCILLATIONS RÉDUIT

(30) Priorität: 16.05.2006 DE 102006022807
(43) Veröffentlichungstag der Anmeldung: 04.02.2009
(73) Patentinhaber: Robert Bosch GmbH, 70442 Stuttgart (DE)
(72) Erfinder: HAAG, Frieder, 72827 Wannweil (DE); KNAUSS, Michael, 70376 Stuttgart (DE); GRABMAIER, Florian, 72074 Tuebingen (DE); HOLZMANN, Martin, 72810 Gomaringen (DE)
(86) Internationale Anmeldenummer: PCT/EP2007/052701
(87) Internationale Veröffentlichungsnummer: WO 2007/131823

(56) Entgegenhaltungen:
- DE-A1- 10 332 303
- DE-A1-102005 041 577
- DE-U1-202005 001 559
- US-A1- 2005 035 446

## Beschreibung

### Stand der Technik

Die Erfindung betrifft ein Chipgehäuse zur Aufnahme einer Chipstruktur, insbesondere eines mikromechanischen Sensors, das sich durch eine reduzierte Schwingungseinkopplung in die Chipstruktur auszeichnet.

Elektronische Bauteile und mikromechanische Sensoren werden im Zuge einer standardisierten Konfektionierung in Gehäuse mit vorbereiteten Kontaktmitteln verpackt, die in der Regel fest mit größeren Schaltungsstrukturen, zumeist Leiterplatten, oder anderen Trägern verbunden werden. Auf Grund der Stressanfälligkeit mikromechanischer Sensoren haben sich für deren Verpackung inzwischen sogenannte Premold-Gehäuse etabliert, deren Grundstruktur gießtechnisch ausgeformt wird, bevor die jeweilige Verbindung zwischen der eigentlichen Chipstruktur mit Sensorfunktionen und dem diese Chipstruktur aufnehmenden Gehäuse hergestellt wird. Üblicherweise wird die Chipstruktur zu diesem Zweck adhäsiv mit einem zentralen Bereich des Premold-Gehäuses, beispielsweise durch Verkleben einer Seite der Chipstruktur mit dem Bodenbereich einer vorbereiteten Kavität, verbunden. Anschließend wird das Gehäuse verschlossen.

Insbesondere mikromechanische Sensoren, die für verschiedene Beschleunigungs- und Bewegungsmessungen eingesetzt werden, müssen selbst vor Störbeschleunigungen geschützt werden, um Beschädigungen oder Fehlfunktionen zu vermeiden. Derartige Störbeschleunigungen können durch Schockeinwirkungen auf das betreffende Bauelement oder Schwingungseinkopplungen über ungenügend gedämpfte Trägerstrukturen auf den jeweiligen Sensor einwirken. Insbesondere die Gefahr von Schwingungseinkopplungen ist bei einem Einsatz der Sensoren im Bereich der Fahrzeugelektronik relativ groß. Es wird daher versucht, die genannten Einflüsse durch konstruktive Maßnahmen gering zu halten.

Zu derartigen konstruktiven Maßnahmen zählen insbesondere im Fahrzeugbau die Auswahl eines Einbauortes, der nur in geringem Maße Störbeschleunigungen ausgesetzt ist und eine schocksichere bzw. schwingungsgedämpfte Montage der Baugruppe, die ein gegenüber Störbeschleunigungen empfindliches Bauelement trägt. Der Aufwand für eine schwingungsgedämpfte Montage ist gegenwärtig relativ hoch, da meist ganze Leiterplatten oder Einbaugeräte schwingungstechnisch vom Rest des Fahrzeuges entkoppelt werden müssen. Die Beschränkung auf Einbauorte mit geringer Belastung durch Störbeschleunigen ist teilweise mit einem ähnlich großen Aufwand verbunden, da es häufig nicht möglich oder erwünscht ist, jeweils die komplette Baugruppe oder das gesamte Einbaugerät an dem für die Platzierung des mikromechanischen Sensors in Frage kommenden Einbauort unterzubringen, wodurch ein erheblicher Verbindungsaufwand zwischen dem eigentlichen Sensor und nachgeschalteter Auswerteelektronik entstehen kann. Beide Lösungen sind somit durch unerwünschte Kostenfaktoren belastet und schränken die Flexibilität insbesondere beim Einsatz von gekapselten mikromechanischen Sensoren ein.

Die Druckschrift DE 10332303 A1 zeigt ein Premold-Gehäuse mit einem schwer deformierbaren Wandbereich, einem leicht deformierbaren Bereich und einem schwer deformierbaren Bodenbereich. Der leicht deformierbare Bereich ist durch eine geringere Materialstärke oder durch eine Faltenbalgstruktur ausgeführt. Die Druckschrift DE 102005041577 A1 zeigt ein Gehäuse und einen Schaltkreis-Chip, sowie einen Sensor-Chip, die in dem Gehäuse angeordnet und gehalten sind. Die Druckschrift zeigt weiter ein Verdrahtungselement, das eine Flexibilität aufweist und durch das der Schaltkreis-Chip und das Gehäuse elektrisch und mechanisch miteinander verbunden sind. Die Druckschrift DE 202005001559 U1 offenbart ein Gehäuse mit einem Hohlraum und einem darin angeordneten Verdrahtungsträger, wobei auf dem Verdrahtungsträger ein Sensor-Chip oder eine MEMS-Struktur montiert ist. Der Hohlraum in dem Gehäuse und der Raum zwischen dem Chip und dem Verdrahtungsträger kann mit einer Gelfüllung versehen oder mit einem Gas gefüllt sein.

### Offenbarung der Erfindung

### Technische Aufgabe

Die Aufgabe der Erfindung besteht in der Angabe einer Möglichkeit, den Aufwand für den Schutz von Sensorelementen vor Störbeschleunigungen zu reduzieren und insbesondere bei automotiven Anwendungen zusätzliche Einbauorte für den Einsatz mikromechanischer Sensoren zu erschließen.

### Technische Lösung

Gelöst wird die Aufgabe durch ein Premold-Gehäuse gemäß Anspruch 1. Die Ansprüche 2 bis 6 geben vorteilhafte Ausgestaltungen eines erfindungsgemäßen Gehäuses an.

Die Erfindung geht davon aus, die Funktionen herkömmlicher Bauteile zur Schwingungsentkopplung und Schocksicherung ganzer Baugruppen oder Einbaugeräte in Bezug auf das mikromechanische Sensorelement zumindest teilweise im Gehäuse des Sensorelements zu realisieren. Dazu wird ein Premold-Gehäuse so ausgebildet, dass sich der Platz, an dem das eigentliche Sensorelement, also die mikromechanische Chipstruktur befestigt werden soll, in die Struktur eines mechanischen Tiefpasses einbezogen wird und über diese Struktur mit dem Rest des Premold-Gehäuses, der mit einer Leiterplatte oder einer vergleichbaren Stützstruktur verbunden wird, in Verbindung steht.

Die Erfindung besteht aus einem Premold-Gehäuse zur Aufnahme einer Chipstruktur, wobei ein Teil des Gehäuses, der mit der Chipstruktur verbunden wird, elastisch auslenkbar mit einem weiteren Teil des Gehäuses, der an einer das gesamte Gehäuse tragenden Stützstruktur befestigt wird, verbunden ist, wobei Mittel zur Dämpfung der Auslenkung des Teiles des Gehäuses, der mit der Chipstruktur verbunden wird, vorhanden sind.

### Vorteilhafte Wirkungen

Auf erfindungsgemäße Weise wird somit verhindert, dass Störbeschleunigungen von dem Gehäuseteil, der fest mit externen Baugruppen verbunden werden kann, auf den Gehäuseteil, der die Chipstruktur trägt, übertragen werden. Insbesondere beim Einsatz mikromechanischer Beschleunigungs- oder Drehratesensoren (Inertialsensoren) lassen sich derartige Premold-Gehäuse mit Vorteil verwenden.

Vorteilhafterweise umfasst der Teil des Gehäuses, der mit der Chipstruktur verbunden wird, eine Bodenplatte, die über mindestens eine Federstruktur, die sich zumindest teilweise in Kontakt mit einem Dämpfungsmaterial befindet, mit einem die Bodenplatte rahmenförmig umgebenden weiteren Teil des Gehäuses, der an einer das gesamte Gehäuse tragenden Stützstruktur befestigt wird, verbunden ist. Ein besonders geringer technologischer Aufwand ergibt sich, wenn die Federstruktur aus dem gleichen Material wie die beiden Gehäuseteile besteht. Dann können die Federstruktur und die beiden Gehäuseteile ein in einem Arbeitsschritt herstellbares Formteil, das in der Regel aus Kunststoff bestehen wird, bilden. Als Gehäusematerialien haben sich insbesondere thermoplastische Materialien oder Epoxid bewährt.

Vorteilhaft und sehr robust sind weitgehend symmetrische Gehäuseausformungen. Dazu kann der Teil des Gehäuses, der mit der Chipstruktur verbunden wird, über Balkenfedern elastisch auslenkbar mit dem Teil des Gehäuses, der an der das gesamte Gehäuse tragenden Stützstruktur befestigt wird, verbunden sein.

Neben der geringen Richtungsabhängigkeit der Schutzwirkung derartiger Gehäuseformen ergeben sich dadurch automatisch konstruktive Möglichkeiten, die Federstruktur mit Mitteln zur Dämpfung der Auslenkung des den Chip tragenden Teiles der Anordnung zu verbinden. Insbesondere hat sich als vorteilhaft erwiesen, wenn die Balkenfedern umgebende Hohlräume zumindest teilweise mit einem schwingungsdämpfenden Material gefüllt werden, wobei das schwingungsdämpfende Material vorteilhafterweise Silikon enthält oder ausschließlich aus Silikon besteht. Dabei stehen die mechanischen Eigenschaften des Silikons im Vordergrund. Silikon dient als elastisch deformierbares Medium, dessen Haftfähigkeit geeignet ist, fest an der Federstruktur anzuhaften, und dessen elastische und dämpfende Volumeneigenschaften geeignet sind, die erfindungsgemäße Auslenkbarkeit bei ausreichender Dämpfung zu ermöglichen. Sein geringer Elastizitätsmodul sorgt gleichzeitig dafür, dass durch das Silikon aufgebrachte Rückstellkräfte die durch die Federstruktur aufgebrachten Rückstellkräfte nur relativ schwach additiv überlagern. In Sinne der Erfindung kann Silikon als Dämpfungsmaterial durch ähnliche oder gleichwirkende Medien ersetzt werden.

Eine maximale Dämpfungswirkung ergibt sich, wenn die zur Verfügung stehenden Volumina vollständig mit dem schwingungsdämpfenden Material gefüllt werden. Auf diese Weise lässt sich eine feste Verbindung zwischen der Federstruktur und dem schwingungsdämpfenden Material entlang einer großen Kontaktfläche herstellen, was die Wirksamkeit der Anordnung erhöht und gleichzeitig dem Schutz der Federstruktur dient.

### Kurze Beschreibung der Zeichnungen

An Ausführungsbeispielen und zugehörigen Zeichnungen wird die Erfindung näher erläutert.

Es zeigen:
- Fig. 1: eine schematische Darstellung eines erfindungsgemäßen Premold-Gehäuses;
- Fig. 2: eine schematische Darstellung des zentralen Bereiches eines erfindungsgemäßen Premold-Gehäuses mit Balkenfedern;

### Ausführungsformen der Erfindung

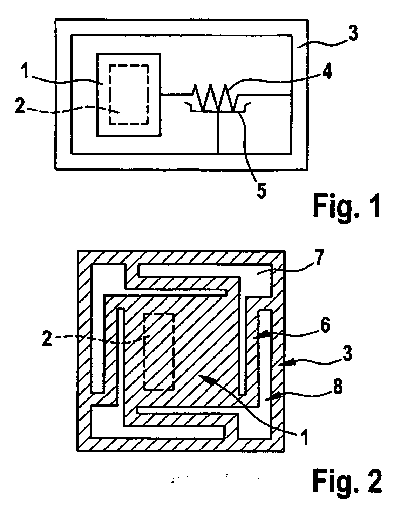

Figur 1 zeigt eine schematische Darstellung eines erfindungsgemäßen Premold-Gehäuses, an der die grundsätzliche Funktionsweise erläutert wird. Ein Teil 1 des Gehäuses, der mit der Chipstruktur 2 verbunden wird, umfasst im Wesentlichen einen zur Aufnahme der Chipstruktur 2 vorbereiteten Bodenbereich. Ein zweiter Teil 3 des Gehäuses, der an einer das gesamte Gehäuse tragenden Stützstruktur befestigt werden kann, umgibt den ersten Teil 1 des Gehäuses in seiner Haupterstreckungsebene vollständig. Die Verbindung zwischen beiden Gehäuseteilen 1, 3 erfolgt über eine Federstruktur 4, die dafür sorgt, dass der erste Teil 1 des Gehäuses gegenüber dem zweiten Teil 3 des Gehäuses elastisch auslenkbar ist. Ein Mittel 5 zur Dämpfung dieser Auslenkung greift an der Federstruktur an und verhindert insbesondere das Auftreten von Resonanzeffekten oder eines zu langen Nachschwingens.

In einer derartigen Anordnung wird ein Feder-Masse-Dämpfer-System, also ein mechanischer Tiefpass, realisiert, wobei eine weitgehende funktionale Trennung zwischen Feder 4 und Dämpfer 5 erfolgt. Durch die Trennung zwischen Feder und Dämpfer ist es möglich, sich bei der Wahl des Materials für die Federstruktur auf eine möglichst geringe Temperaturabhängigkeit des Elastizitätsmoduls zu konzentrieren. Dieser bestimmt bei konstanter Masse im Wesentlichen die Resonanzfrequenz bzw. die Frequenz, mit der die Anordnung ohne äußere Anregung nachschwingt. Da insbesondere bei automotiven Anwendungen der zu erwartende Frequenzbereich, mit dem eine Einkopplung von Schwingungen als Form von Störbeschleunigungen erfolgen kann, bekannt ist, wird das erfindungsgemäße Gehäuse so ausgelegt, dass die Resonanzfrequenz unterhalb dieses zu erwartenden Frequenzbereiches liegt. Durch Auswahl eines Materials mit weitgehend temperaturunabhängigem Elastizitätsmodul kann diese Auslegung zudem einen großen Temperaturbereich abdecken, ohne dass bei bestimmten Betriebstemperaturen die Gefahr einer starken Einkopplung von Schwingungen besteht.

Die Dämpfungseigenschaften des Materials, aus dem die Federstruktur besteht, sind in der vorliegenden Erfindung zu vernachlässigen, da die Funktion des Dämpfers von einem anderen Material übernommen wird. Dadurch können zur Ausbildung der Federstruktur Materialien, insbesondere thermoplastische Werkstoffe oder Epoxid, eingesetzt werden, die üblicherweise für die Herstellung von Chipgehäusen verwendet werden. Diese zeichnen sich in der Regel durch einen großen Elastizitätsmodul bei geringer Temperaturabhängigkeit aus, weisen jedoch schlechte Dämpfungseigenschaften auf. Als Dämpfer.dient ein elastischer Kunststoff mit guten Dämpfungseigenschaften, vorzugsweise ein Silikonwerkstoff aus den bereits genannten Gründen.

Figur 2 ist eine schematische Darstellung des zentralen Bereiches eines erfindungsgemäßen Premold-Gehäuses mit Balkenfedern 6 als verbindender Federstruktur. Ein erster Teil 1 des Gehäuses, der mit der Chipstruktur verbunden wird, ist als quadratischer Bereich ausgebildet, der über vier jeweils mit einer Ecke des quadratischen Bereiches verbundene Balkenfedern 6 mit dem zweiten Gehäuseteil 3 im Verbindung steht.

Der zweite Gehäuseteil 3 weist an seiner Unterseite nicht dargestellte Mittel auf, die eine Lötverbindung mit einer Leiterplatte ermöglichen, wodurch die Befestigung an einer das gesamte Gehäuse tragenden Stützstruktur im Sinne der vorliegenden Erfindung beispielhaft realisiert wird.

Zwischen den beiden Gehäuseteilen 1, 3 befindet sich ein Zwischenraum 7, der eine ausreichende Auslenkbarkeit des zentralen quadratischen Bereiches ermöglicht. Dieser Zwischenraum wird durch die Balkenfedern 6 überbrückt, ohne von den Balkenfedern 6 vollständig ausgefüllt zu werden. Der die Balkenfedern umgebende Hohlraum 8, der durch die beiden Gehäuseteile 1, 3 begrenzt wird, ist mit Silikon, das als schwingungsdämpfendes Material wirkt, gefüllt.

Die Länge der Balkenfedern 6 entspricht etwa der Seitenlänge des quadratischen Bereiches. Die Balkenfedern 6 weisen dabei eine Haupterstreckungsrichtung parallel zum Rand des quadratischen Bereiches auf und sind jeweils über abgewinkelte Bereiche mit den beiden Gehäuseteilen 1, 3 verbunden. Diese Geometrie ermöglicht eine relativ große Federlänge bei kleinem Platzbedarf. Durch Variation der Federlänge und/oder des Querschnitts der Balkenfedern 6 lässt sich in Kenntnis der Masse des chipbestückten Bereiches 1 die Resonanzfrequenz der Anordnung und somit die Eckfrequenz des als mechanischer Tiefpass wirkenden Systems festlegen.

Durch die vorliegend große Länge der Balkenfedern 6 und die vollständige Füllung der Federumgebung mit Silikon ergibt sich eine feste Verbindung zwischen der Federstruktur und dem schwingungsdämpfenden Material entlang einer großen Kontaktfläche, was die Wirksamkeit der Dämpfung erhöht und gleichzeitig dem Schutz der Federstruktur dient. Die dargestellte Geometrie lässt sich durch Herstellung eines einzigen Formteiles realisieren. Vorliegend bilden die Federstruktur aus vier Balkenfedern 6 und die beiden Gehäuseteile 1, 3 ein Formteil aus PEEK (Polyetheretherketon).

Der Teil des Gehäuses 1, der mit der Chipstruktur verbunden wird, bildet eine schwingungsentkoppelte Bodenfläche, die über eine Feder-Dämpfer-Anordnung mit dem anderen Teil 3 des Gehäuses in Verbindung steht. Oberhalb der Eckfrequenz dieses als mechanischer Tiefpasswirkenden Systems erfolgt nur noch eine sehr geringe oder keine relevante Einkopplung von Schwingungen in die Bodenfläche, wodurch dieser Typ von Störbeschleunigungen sowie kurzzeitige Schockeinwirkungen im Rahmen der konstruktiv bedingten Auslenkbarkeit von einer auf diesem Gehäuseteil 1 befestigten Chipstruktur ferngehalten werden.

Der hohe Grad an Symmetrie der die Gehäuseformen der vorangegangenen Ausführungsbeispiele, insbesondere die Geometrie der Federstrukturen, auszeichnet, sorgt für eine geringe Richtungsabhängigkeit der Schutzwirkung der erfindungsgemäßen Gehäuseformen. Das ermöglicht insbesondere bei automotiven Verwendungen der Erfindung die Erschließung zahlreicher Einbauorte, da auf eine besondere Ausrichtung des Bauelementes kaum geachtet werden muss.

Durch die erfindungsgemäße Integration eines vollständigen mechanischen Tiefpasses in ein Premold-Gehäuse können weitere Maßnahmen zur schwingungstechnischen Entkopplung des Sensorchips entfallen. Da auf Grund der geringen Massen üblicher Chipstrukturen sehr kleine Federkonstanten erforderlich sind, um insbesondere in Fahrzeugen auftretende Schwingungen im Bereich um 1 kHz sicher abzuschirmen, stellen die mit geringem technologischem Aufwand anpassbaren Geometrien der Federstrukturen der Ausführungsbeispiele einen weiteren Vorteil der Erfindung dar.

In erfindungsgemäßen Gehäusen integrierte Chips lassen sich ohne Probleme an verschiedenen Einbauorten in Fahrzeugen verwenden, ohne dass eine räumliche Trennung zwischen dem Chip und einer nachgeschalteten Auswerteelektronik erforderlich wird. Das hilft, den Verbindungsaufwand für verschiedene Applikationen insbesondere mikromechanischer Sensoren zu reduzieren.

## Patentansprüche

1. Premold-Gehäuse zur Aufnahme einer Chipstruktur, wobei
ein Teil (1) des Gehäuses, der mit der Chipstruktur (2) verbunden wird, elastisch auslenkbar mit einem weiteren Teil (3) des Gehäuses, der an einer das gesamte Gehäuse tragenden Stützstruktur befestigt wird, verbunden ist, wobei Mittel zur Dämpfung (5) der Auslenkung des Teiles (1) des Gehäuses, der mit der Chipstruktur (2) verbunden wird, vorhanden sind, wobei der Teil (1) des Gehäuses, der mit der Chipstruktur (2) verbunden wird, eine Bodenplatte umfasst, die über mindestens eine Federstruktur (4), die sich zumindest teilweise in Kontakt mit einem Dämpfungsmaterial (5) befindet, mit einem die Bodenplatte rahmenförmig umgebenden weiteren Teil (3) des Gehäuses, der an einer das gesamte Gehäuse tragenden Stützstruktur befestigt wird, verbunden ist, wobei die Federstruktur (4) und die beiden Gehäuseteile (1, 3) ein in einem Arbeitsschritt herstellbares Kunststoffteil, insbesondere aus einem thermoplastischen Material oder Epoxid, bilden, wobei der Teil (1) des Gehäuses, der mit der Chipstruktur (2) verbunden wird, über Balkenfedern (6) elastisch auslenkbar mit dem Teil (3) des Gehäuses, der an der das gesamte Gehäuse tragenden Stützstruktur befestigt wird, verbunden ist.

2. Premold-Gehäuse nach Anspruch 1, **dadurch gekennzeichnet, dass** die Federstruktur (4) aus dem gleichen Material wie die beiden Gehäuseteile (1, 3) besteht.

3. Premold-Gehäuse nach Anspruch 1, **dadurch gekennzeichnet, dass** die Federstruktur (4) und die beiden Gehäuseteile (1, 3) ein Formteil aus PEEK (Polyetheretherketon) bilden.

4. Premold-Gehäuse nach Anspruch 1, **dadurch gekennzeichnet, dass** die Balkenfedern (6) umgebende Hohlräume (8) zumindest teilweise mit einem schwingungsdämpfenden Material gefüllt sind.

5. Premold-Gehäuse nach Anspruch 4, **dadurch gekennzeichnet, dass** das schwingungsdämpfende Material Silikon enthält.

6. Premold-Gehäuse nach einem der Ansprüche 1 bis 4, **dadurch gekennzeichnet, dass** die aufzunehmende Chipstruktur (2) einen mikromechanischen Beschleunigungssensor oder Drehratensensor umfasst, und der Teil (3) des Gehäuses, der an einer das gesamte Gehäuse tragenden Stützstruktur befestigt wird, Mittel aufweist, die eine Lötverbindung mit einer Leiterplatte ermöglichen.

## Claims

1. Premould housing for accommodating a chip structure, wherein a part (1) of the housing that is connected to the chip structure (2) is connected in an elastically deflectable manner to a further part (3) of the housing, said further part being fixed to a supporting structure carrying the entire housing, wherein means for damping (5) the deflection of the part (1) of the housing that is connected to the chip structure (2) are present, wherein the part (1) of the housing that is connected to the chip structure (2) comprises a baseplate, which is connected, by means of at least one spring structure (4) that is at least partly in contact with a damping material (5) to a further part (3) of the housing, said further part surrounding the baseplate in a frame-tight manner and being fixed to a supporting structure carrying the entire housing, wherein the spring structure (4) and the two housing parts (1, 3) form a plastic part, in particular composed of a thermoplastic material or epoxide, which plastic part can be produced in one work step, wherein the part (1) of the housing that is connected to the chip structure (2) is connected in an elastically deflectable manner, by means of beam springs (6), to the part (3) of the housing that is fixed to the supporting structure carrying the entire housing.

2. Premould housing according to Claim 1, **characterized in that** the spring structure (4) consists of the same material as the two housing parts (1, 3).

3. Premould housing according to Claim 1, **characterized in that** the spring structure (4) and the two housing parts (1, 3) form a shaped part composed of PEEK (polyether ether ketone).

4. Premould housing according to Claim 1, **characterized in that** cavities (8) surrounding the beam springs (6) are at least partly filled with a vibration-damping material.

5. Premould housing according to Claim 4, **characterized in that** the vibration-damping material contains silicone.

6. Premould housing according to any of Claims 1 to 4, **characterized in that** the chip structure (2) to be accommodated comprises a micromechanical acceleration sensor or rate-of-rotation sensor, and the part (3) of the housing that is fixed to a supporting structure carrying the entire housing has means which enable a soldering connection to a printed circuit board.

## Revendications

1. Boîtier prémoulé destiné à recevoir une structure de puce, une partie (1) du boîtier, qui est reliée à la structure de puce (2), étant reliée de manière à pouvoir être déviée élastiquement à une autre partie (3) du boîtier qui est fixée à une structure de support qui supporte la totalité du boîtier, des moyens d'amortissement (5) de la déviation de la partie (1) du boîtier qui est reliée à la structure de puce (2) étant prévus, la partie (1) du boîtier qui est reliée à la structure de puce (2) comportant une plaque de fond qui est reliée, par l'intermédiaire d'au moins une structure de ressort (4) qui se trouve au moins partiellement en contact avec un matériau d'amortissement (5), à une autre partie (3) du boîtier qui entoure à la manière d'un cadre la plaque de fond et qui est fixée à une structure de support qui supporte la totalité du boîtier, la structure de ressort (4) et les deux parties de boîtier (1, 3) formant une partie en plastique, en particulier en un matériau thermoplastique ou en époxy, qui peut être fabriquée en une étape de travail, la partie (1) du boîtier qui est reliée à la structure de puce (2) étant reliée, par l'intermédiaire de ressorts en forme de barre (6), de manière à pouvoir être déviée élastiquement, à la partie (3) du boîtier qui est fixée à la structure de support qui supporte la totalité du boîtier.

2. Boîtier prémoulé selon la revendication 1, **caractérisé en ce que** la structure de ressort (4) est constituée du même matériau que celui des deux parties de boîtier (1, 3).

3. Boîtier prémoulé selon la revendication 1, **caractérisé en ce que** la structure de ressort (4) et les deux parties de boîtier (1, 3) forment une pièce moulée en PEEK (polyétheréthercétone).

4. Boîtier prémoulé selon la revendication 1, **caractérisé en ce que** des cavités (8) entourant les ressorts en forme de barre (6) sont remplies au moins partiellement d'un matériau amortissant les vibrations.

5. Boîtier prémoulé selon la revendication 4, **caractérisé en ce que** le matériau amortissant les vibrations contient de la silicone.

6. Boîtier prémoulé selon l'une quelconque des revendications 1 à 4, **caractérisé en ce que** la structure de puce (2) à recevoir comporte un capteur d'accélération micromécanique ou un capteur de vitesse de rotation, et la partie (3) du boîtier qui est fixée à une structure de support qui supporte la totalité du boîtier comprend des moyens qui permettent une liaison soudée à une carte de circuits imprimés.
